# EUROPEAN PATENT APPLICATION

(11) **EP 4 618 123 A1**
(43) Date of publication of application: **17.09.2025**
(21) Application number: 23929877.1
(22) Date of filing: 12.10.2023
(51) Int. Cl.: H01H 9/04

(54) **CONTROL BOX IN ENERGY STORAGE DEVICE AND ENERGY STORAGE DEVICE**

(30) Priority: 31.03.2023 CN 202320696366 U
(71) Applicant: Contemporary Amperex Technology (Hong Kong) Limited, Hong Kong (HK)
(72) Inventor: LUO, Chunbiao, Ningde, Fujian 352100 (CN)
(74) Representative: Ziebig Hengelhaupt Intellectual Property Attorneys Patentanwaltskanzlei PartGmbB
(86) International application number: PCT/CN2023/124315
(87) International publication number: WO 2024/198304

(57) **Abstract**

Embodiments of the present application provide a control box in an energy storage device and an energy storage device. The control box in the energy storage device comprises: a first wall; a switch assembly that is arranged on the first wall; and a protective cover that covers the switch assembly. An edge area of the protective cover is rotatably connected to the first wall by means of a first connecting piece, and the protective cover is fixedly connected to the first wall by means of a detachable second connecting piece. Where the switch assembly does not need to be operated, the possibility of impurities in the external environment entering the control box to cause failure of the control box can be reduced. Where the switch assembly needs to be operated or maintained, the first connecting piece can enable the protective cover to rotate relative to the first wall, without the need to completely disassemble the protective cover, reducing the possibility of losing the protective cover, which is beneficial for the protection of the switch assembly, thereby reducing the possibility of failure of the control box.

## Description

The present application claims priority to Chinese Patent Application No. 202320696366.1 filed to China National Intellectual Property Administration on March 31, 2023, and entitled "CONTROL BOX IN ENERGY STORAGE DEVICE AND ENERGY STORAGE DEVICE", the content of which is incorporated herein by reference in its entirety.

### TECHNICAL FIELD

Embodiments of the present application relate to the technical field of batteries, and in particular, to a control box in an energy storage device and an energy storage device.

### BACKGROUND

Against the backdrop of the rapid development of new energy technologies, various energy storage-related technologies are of important research significance. Energy storage devices are generally capable of accommodating a plurality of energy storage elements and other functional components that manage the plurality of energy storage elements or support the operation of these elements, where a control box in the energy storage device is an important component for the management on the energy storage device.

Therefore, how to lower the possibility of failure of the control box is still a problem to be resolved.

### SUMMARY

Embodiments of the present application provide a control box in an energy storage device and an energy storage device, which can lower the possibility of failure of the control box.

In a first aspect, a control box in an energy storage device is provided, which includes: a first wall; a switch assembly, the switch assembly being arranged on the first wall; and a protective cover, where the protective cover covers the switch assembly, an edge area of the protective cover is rotatably connected to the first wall through a first connecting member, and the protective cover is fixedly connected to the first wall through a detachable second connecting member.

The protective cover of the switch assembly is arranged on the first wall in two different connection modes. In the case where the switch assembly does not need to be operated, the second connecting members may maintain the fixed connection between the protective cover and the first wall, such that the first wall can maintain a good waterproof and dustproof effect, thereby lowering the possibility that impurities in the external environment enter the control box to cause failure of the control box. In the case where the switch assembly needs to be operated or maintained, the first connecting member may enable the protective cover to rotate relative to the first wall without the need to completely detach the protective cover, such that the possibility of losing the protective cover is reduced and the protection for the switch assembly is facilitated, thus lowering the possibility of failure of the control box.

In some embodiments, the protective cover includes a first groove opening toward the first wall, the first groove being configured to accommodate at least a part of the switch assembly; and/or the first wall is provided with a second groove opening toward the protective cover, the second groove being configured to accommodate at least a part of the switch assembly.

By arranging the first groove and/or the second groove to accommodate the switch assembly, the clearance for the switch assembly can be achieved, the possibility of interference between different structures is reduced, and the normal work of the control box is facilitated, thus lowering the possibility of failure of the control box.

In some embodiments, the first groove is arranged opposite to the second groove.

The arrangement of the first groove opposite to the second groove can reduce unnecessary space waste and facilitate the reasonable layout of the components on the control box, thus facilitating the fabrication of the control box with a suitable dimension.

In some embodiments, the first connecting member is arranged on one side of the protective cover facing a gravity direction, the first groove protrudes from the protective cover along a first direction, and a dimension of the first groove protruding from the first wall is greater than or equal to a dimension of the first connecting member protruding from the first wall, where the first direction is a thickness direction of the first wall.

The part of the first groove protruding from the first wall can shield the first connecting member in the gravity direction, such that the first connecting member is not easily affected by water accumulation or water seepage above the control box, thus lowering the possibility of damage caused by corrosion of the first connecting member, and facilitating the extension of the service life of the first connecting member.

In some embodiments, the control box further includes: a shielding structure, wherein the shielding structure is arranged on one side of the first connecting member along a direction opposite to the gravity direction, and a projection of the shielding structure in the gravity direction covers a projection of the first connecting member in the gravity direction.

The shielding structure can reduce the accumulation of dust or water in the external environment on the first connecting member for the first connection, and then lower the possibility of damage caused by corrosion of the first connecting member, and facilitate the extension of the service life of the first connecting member, thus lowering the possibility of failure of the control box.

In some embodiments, the surface of the shielding structure facing a direction opposite to the gravity direction is the first surface, and the first surface is inclined, in a second direction, from the central area to both ends along the gravity direction, where the second direction is perpendicular to the thickness direction of the first wall and the gravity direction.

Under the action of gravity, this type of structure is conducive to guiding dust or water to slide off along the inclined first surface on the shielding structure, such that the dust or water does not accumulate on the shielding structure, thus reducing the load bearing of the shielding structure, and facilitating the extension of the service life of the shielding structure, thereby lowering the possibility of dust or water falling on the first connecting member and lowering the possibility of failure of the control box.

In some embodiments, the control box further includes: a guiding part, the guiding part being connected to the shielding structure and arranged on both ends of the shielding structure along the second direction, the second direction being perpendicular to the thickness direction of first wall and the gravity direction.

The guiding part may further guide dust and water to slide off along a certain path, which is conducive to providing a better protective effect on the first connecting member. Meanwhile, the guiding part may further reduce the accumulation of dust or water on the shielding structure and lower the possibility that dust or water falls on the first connecting member, thus facilitating the extension of the service life of the first connecting member.

In some embodiments, the control box further includes: a sealing member, the sealing member being arranged between the protective cover and the first wall for sealing a surrounding area of the switch assembly.

The sealing member is conducive to sealing the periphery of the switch assembly, such that the control box is not easily affected by the dust and water in the external environment, thus lowering the possibility that impurities in the external environment enter the control box to cause failure of the control box and enabling the waterproof and dustproof effect of the control box to be further improved, thereby lowering the possibility of failure of the control box.

In some embodiments, the second connecting members are configured to connect the first wall, the sealing member, and the protective cover.

In the case where the protective cover maintains fixed connection to the first wall, by connecting the first wall, the sealing member, and the protective cover through the second connecting members, the three components can be more tightly disposed together, which is conducive to improving the sealing performance of the sealing member.

In some embodiments, in a length direction of the edge area, a value range of a ratio of a length of the first connecting member to a length of the edge area is [1/4, 1/2].

If the ratio of the length of the first connecting member to the length of the edge area is too small, it may be difficult to maintain the connection between the protective cover and the first wall, which may easily lead to damage to the first connecting member during use. If the ratio of the length of the first connecting member to the length of the edge area is too large, the possibility that dust and water in the external environment enter the switch assembly through the gap between the first connecting member and the first wall is likely to be increased, thus leading to the increase in the probability of failure of the control box.

In some embodiments, the first connecting member includes a hinge, and/or the second connecting members include bolts.

By rotatably connecting the protective cover to the first wall through the hinge, the rotation of the protective cover relative to the first wall may be convenient to achieve. In some embodiments, by connecting the protective cover to the first wall through the bolts, the detachment and mounting between the protective cover and the first wall can be achieved through a relatively mature process, thus lowering the manufacturing cost.

In a second aspect, an energy storage device is provided, which includes the control box described in any one of the above embodiments.

In the embodiments according to the present application, the protective cover of the switch assembly is arranged on the first wall in two different connection modes. In the case where the switch assembly does not need to be operated, the second connecting member can maintain the fixed connection between the protective cover and the first wall, such that the first wall can maintain a better waterproof and dustproof effect, thereby lowering the possibility that impurities in the external environment enter the control box to cause failure of the control box. In the case where the switch assembly needs to be operated or maintained, the first connecting member can enable the first connecting member to rotate relative to the protective cover without the need to completely detach the protective cover, thus reducing the possibility of losing the protective cover and facilitating the protection for the switch assembly, thereby lowering the possibility of failure of the control box.

### BRIEF DESCRIPTION OF THE DRAWINGS

FIG. 1 is a schematic structural diagram of an energy storage device according to the embodiments of the present application.
FIG. 2 is a schematic diagram of an exploded structure of a control box according to the embodiments of the present application.
FIG. 3 is a schematic partial structural diagram of a control box according to the embodiments of the present application.
FIG. 4 is a schematic partial structural diagram of a control box according to the embodiments of the present application.
FIG. 5 is a schematic diagram of an exploded structure of a control box according to the embodiments of the present application.
FIG. 6 is a schematic partial structural diagram of a control box according to the embodiments of the present application.
FIG. 7 is a schematic diagram of an exploded structure of a control box according to the embodiments of the present application.
FIG. 8 is a schematic partial structural diagram of a control box according to the embodiments of the present application.
FIG. 9 is a schematic partial structural diagram of a control box according to the embodiments of the present application.
FIG. 10 is a schematic partial structural diagram of a control box according to the embodiments of the present application.
FIG. 11 is a schematic diagram of an exploded structure of a control box according to the embodiments of the present application.
FIG. 12 is a schematic structural diagram of a protective cover according to the embodiments of the present application.

### DETAILED DESCRIPTION

Implementations of the present application will be described in further detail with reference to the drawings and embodiments. The following detailed description of the embodiments and the drawings are used for the exemplary illustration of the principles of the present application, but are not intended to limit the scope of the present application. That is, the present application is not limited to the described embodiments.

In the description of the present application, it should be noted that, unless otherwise specified, "a plurality" means two or more; the orientations or positional relationships indicated by the terms "upper", "lower", "left", "right", "inner", "outer", and the like are merely for the convenience of describing the present application and simplifying the description, rather than indicating or implying that the apparatus or element referred to must have a specific orientation or be configured and operated in the specific orientation, and thus shall not be construed as limitations to the present application. Furthermore, the terms "first", "second", "third", and the like are used for descriptive purposes only and shall not be construed as indicating or implying relative importance. The "perpendicular" is not strictly perpendicular but is within the allowable range of error. The "parallel" is not strictly parallel but is within the allowable range of error.

The following description is given with the directional terms as illustrated in the drawings and is not intended to limit the specific structure of the present application. In the description of the present application, it should further be noted that unless otherwise explicitly specified or defined, the terms "mount", "connect", and "link" shall be construed broadly and may be, for example, fixed connection, detachable connection, or integral connection, or direct connection or indirect connection via an intermediate. For those of ordinary skills in the art, the specific meaning of the above terms in the present application may be interpreted according to the specific condition.

In the present application, the term "and/or" is only an association relationship that describes the associated objects, and indicates that there may be three relationships. For example, A and/or B may indicate that: only A is present, both A and B are present, and only B is present. In addition, the character "/" herein generally indicates an "or" relationship between the associated objects before and after the "/".

Unless otherwise defined, all technical and scientific terms used in the present application have the same meaning as commonly understood by those of ordinary skill in the art to which the present application belongs. The terms used in the specification of the present application are only used to describe specific embodiments and are not intended to limit the present application. The terms "include", "comprise", "have", and any variants thereof in the specification and claims of the present application and the above description of the drawings are intended to cover a non-exclusive inclusion. The terms "first", "second", and the like in the specification and claims of the present application and the above drawings are used to distinguish different objects and are not intended to describe a specific order or priority.

Reference in the present application to "embodiment" means that a particular feature, structure, or characteristic described in connection with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the described embodiments of the present application can be combined with other embodiments.

An energy storage device is a device that stores energy and is generally capable of accommodating one or more energy storage elements, where the energy storage elements may be, for example, batteries. A battery is also referred to as an electrical box, which includes a box body and one or more battery cells encapsulated by the box body. For example, battery cells may include, but are not limited to, lithium-ion secondary batteries, lithium-ion primary batteries, lithium-sulfur batteries, sodium-lithium-ion batteries, sodium-ion batteries, or magnesium-ion batteries, etc. The battery cell may be, but is not limited to, cylindrical, flat, rectangular parallelepiped shaped, or in other shapes.

The energy storage device may also be provided with functional components to manage the plurality of energy storage elements or support the operation of these elements. For example, the energy storage device may be provided with a thermal management component. The thermal management component includes, but is not limited to, an air conditioning assembly, a fan assembly, a water cooling duct, and the like, which can be configured to perform thermal management on the interior of the energy storage device to regulate the temperature within the energy storage device. For another example, the energy storage device may be provided with a control box to monitor and control various states of the energy storage device. In some embodiments, a plurality of batteries may be connected in series, in parallel, or in series-parallel to each other and connected to a main control component through a busbar component; and the electrical connection between the plurality of batteries can be controlled through the main control component.

To enable the control box to work normally, the control box generally needs to have certain waterproof and dustproof levels, and especially some functional components on the control box, such as a switch, a display screen, and an operation panel, require enhanced waterproof and dustproof measures to reduce the influence of the external environment on the normal work of the control box. The switch components on the control box especially need to take enhanced waterproof and dustproof measures, otherwise, water and dust may easily enter the control box through the switch components, causing failure of the control box. When the switch components on the control box need to be operated or the control box needs to be maintained, the protective structure on the switch components generally needs to be detached. After the operation or maintenance is completed, the protective structure is then remounted.

However, the protective structure on the switch components is easy to lose after being detached, and it is also easy to forget to mount the protective structure after the operation or maintenance is completed, resulting in the switch components being exposed to the external environment, such that impurities in the external environment can easily enter the control box through the gap in the switch assembly, thus causing failure of the control box.

Given this, in the embodiments of the present application, a control box in the energy storage device is provided. A protective cover is arranged on the switch components of the control box. The protective cover is rotatably connected to the wall of the control box through a first connecting member and fixedly connected to the wall of the control box through a detachable second connecting member. In the control box according to the embodiments of the present application, the protective cover of the switch components, when in an undetached state, can be fixedly connected to the wall of the control box through the second connecting member, thus keeping a better waterproof and dustproof effect. After the second connecting member is detached, the protective cover can be rotatably connected to the wall of the control box through the first connecting member, thus facilitating the protective cover, after the operation or maintenance is completed, to be fixedly connected to the wall of the control box through the second connecting member. This can lower the probability of losing the protective cover, which is conducive to reducing the risk of failure of the waterproof and dustproof functions of the control box, thus lowering the possibility of failure of the control box.

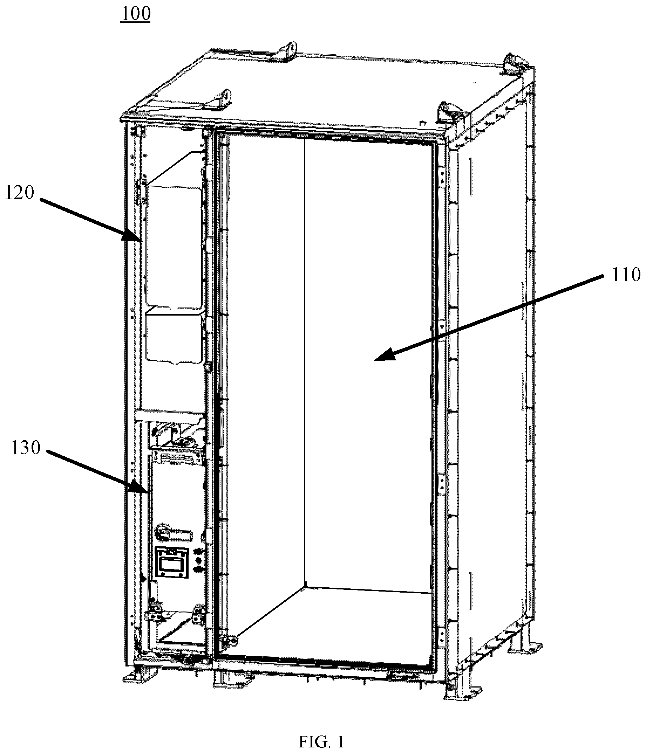

The technical solutions according to the embodiments of the present application are suitable for energy storage devices of various types and dimensions. The description is provided below by taking FIG. 1 as an example. FIG. 1 illustrates an overall schematic diagram of an energy storage device according to the embodiments of the present application.

As shown in FIG. 1, the energy storage device 100 may be, for example, a regular rectangular parallelepiped structure, in which six faces of the rectangular parallelepiped are six outer walls of the energy storage device 100. The arrangement of the energy storage device 100 into a rectangular parallelepiped structure can be convenient for the fixed placement and transportation of the energy storage device 100.

The interior of the energy storage device 100 is a hollow structure. The hollow structure may be divided into a plurality of functional compartments according to actual requirements. For example, the energy storage device 100 shown in FIG. 1 may be divided into an energy storage compartment 110, a thermal management compartment 120, and a control compartment 130. The energy storage compartment 110 may be configured to accommodate the energy storage element to provide electric energy. The thermal management compartment 120 may be configured to accommodate the thermal management component to regulate the temperature of the batteries inside the energy storage device 100. The control compartment 130 may be configured to accommodate the control box to manage the components in the energy storage device 100 or support the operation of these components.

In some embodiments, as shown in FIG. 1, one side of the energy storage device 100 is provided with an energy storage compartment 110, and the other side is provided with a thermal management compartment 120 and a control compartment 130. The thermal management compartment 120 is arranged above the control compartment 130.

In some embodiments, the thermal management compartment 120 is arranged below the control compartment 130.

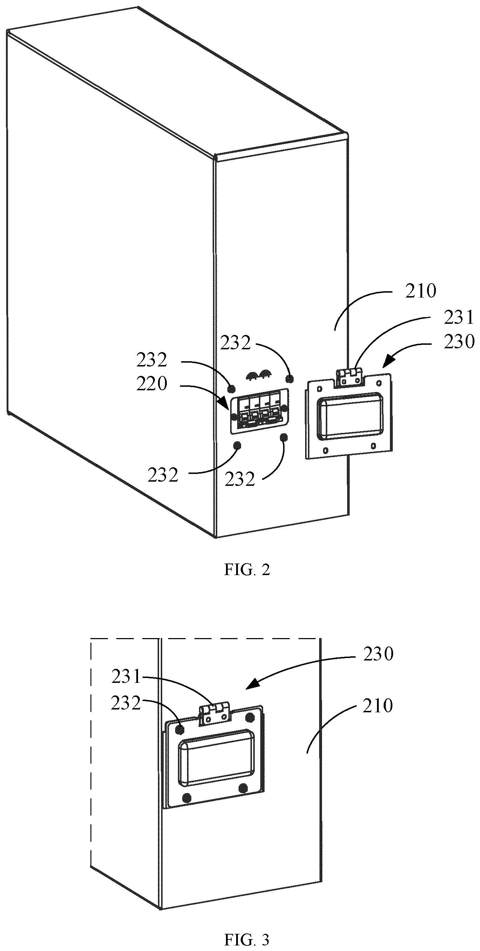

FIG. 2 illustrates a schematic structural diagram of a control box 200 in an energy storage device 100 according to the embodiments of the present application. As shown in FIG. 2, the control box 200 includes a first wall 210, a switch assembly 220, and a protective cover 230.

The switch assembly 220 is arranged on the first wall 210. The protective cover 230 covers the switch assembly 220. The edge area of the protective cover 230 is rotatably connected to the first wall 210 through a first connecting member 231, and the protective cover 230 is fixedly connected to the first wall 210 through detachable second connecting members 232.

The switch assembly 220 refers to a structure on the control box 200 for controlling the on/off of the power supply of the control box 200, and for example, the switch assembly 220 may be an air switch. One surface of the switch assembly 220 is generally facing the outside of the control box 200, so as to facilitate the operation of the switch assembly 220. The other surface of the switch assembly 220 may be connected to the structure inside the control box 200, for example, may be connected to a control circuit inside the control box 200, and by controlling the on/off of the circuit inside the control box 200, the on/off of the control box 200 is achieved.

The first wall 210 refers to a wall on which the switch assembly 220 is arranged. In some embodiments, the control box 200 may include a box body, and thus the first wall 210 may be a wall of the box body. In some embodiments, the first wall 210 may be, for example, a wall of the control box 200 facing the door of the energy storage device 100, on which some components may be arranged, such as interfaces or knobs.

Considering that the switch assembly 220 cannot achieve high sealing performance and impurities in the external environment can easily enter the control box 200 through the gap in the switch assembly 220 to cause failure of the control box 200, therefore, the protective cover 230 needs to be used to protect the switch assembly 220. The switch assembly 220 is arranged on the first wall 210, and thus the protective cover 230 may also be arranged on the first wall 210. To provide a better protective effect, the protective cover 230 at least covers the switch assembly 220, thus reducing the impurities in the external environment entering the control box 200.

The first connecting member 231 is a rotatable connecting structure that connects the protective cover 230 to the first wall 210. The protective cover 230, in the case of being connected to the first wall 210 through the first connecting member 231 only, may rotate through the first connecting member 231 without being completely separated from the first wall 210. The first connecting member 231 is arranged on the edge of the protective cover 230. In one embodiment, the protective cover 230 may rotate with the edge on which the first connecting member 231 is located as the axis. In another embodiment, the protective cover 230 may rotate on a plane substantially parallel to the plane where the first wall 210 is located with the area on which the first connecting member 231 is located as a center point. In some embodiments, in the case where the protective cover 230 includes a plurality of edges, the first connecting member 231 may be arranged on the edge of any one side of the protective cover 230. For example, as shown in FIG. 2, the protective cover 230 may be substantially seen as a rectangle, and thus the first connecting member 231 may be arranged on any one side of the rectangle. In some embodiments, in the case where the protective cover 230 includes one edge, the first connecting member 231 may be arranged at any position of the edge. For example, the protective cover 230 may be of a circular shape, and thus the first connecting member 231 may be arranged at any position of the circumference of the circle. In some embodiments, a plurality of first connecting members 231 may be arranged on the same edge of the protective cover 230.

The second connecting members 232 are detachable fixed connecting structures connecting the protective cover 230 and the first wall 210. The second connecting members 232 can enable the protective cover 230 and the first wall 210 to have a certain connecting strength. The protective cover 230, in the case of being connected to the first wall 210 through both the first connecting member 231 and the second connecting members 232, may be fixed to the first wall 210 under the action of the second connecting members 232, such that the protective cover 230 is not easy to fall off and not easy to rotate relative to the first wall 210, either. The second connecting members 232 may be, for example, bolts and/or nuts. The fixed connection between the protective cover 230 and the first wall 210 can be achieved via the through holes correspondingly formed in the protective cover 230 and the first wall 210. The position of the second connecting member 232 may be offset from the position of the first connecting member. Taking FIG. 2 as an example, the second connecting members 232 may be disposed on the surrounding areas of the protective cover 230, and in some embodiments, these surrounding areas may be attached to the first wall 210.

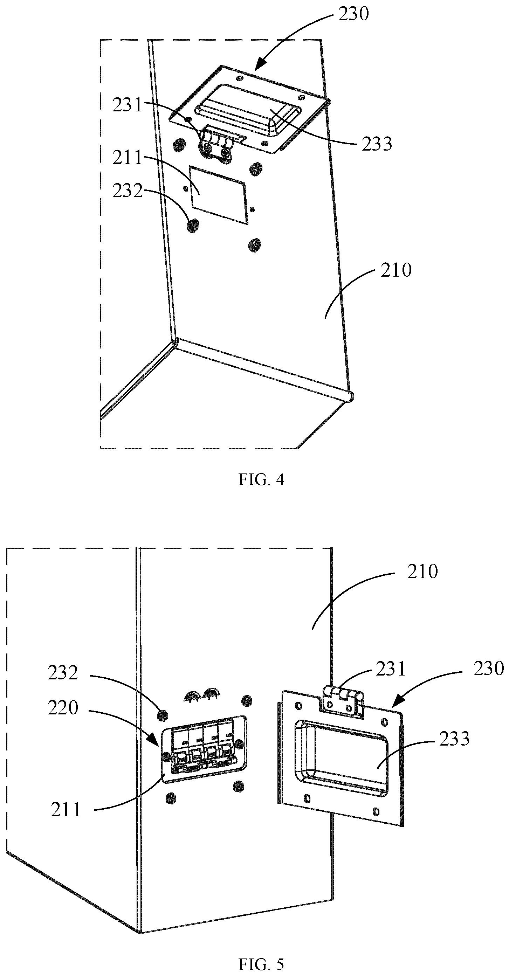

In a normal working state of the control box 200, the protective cover 230 is simultaneously connected to the first wall 210 through the first connecting member 231 and the second connecting members 232, as shown in FIG. 3. Under the action of the second connecting members 232, the first connecting member 231 only achieves the connection between the protective cover 230 and the first wall 210 and the protective cover does not rotate relative to the first wall 210 through the first connecting member 231. In the case where the switch assembly 220 of the control box 200 needs to be operated or maintained, the second connecting members 232 may be detached, and the protective cover 230 is connected to the first wall 210 through the first connecting member 231 only, as shown in FIG. 4 (the switch assembly 220 is omitted), and thus the protective cover 230 may rotate relative to the first wall 210, enabling the switch assembly 220 to be exposed to facilitate the operation or maintenance. In the case where the operation or maintenance of the switch assembly 220 is completed, the second connecting members 232 may be mounted on the protective cover 230 to restore the fixed connection between the protective cover 230 and the first wall 210, such that the protective cover 230 can maintain the protective effect for the switch assembly 220 when the switch assembly 220 does not need to be operated or maintained.

In some embodiments, the second connecting members 232 may be arranged on the protective cover 230 in a manner that is uneasy to fall off. For example, the second connecting members 232, after being detached, may maintain a certain connection to the protective cover 230. This type of structure can further reduce the possibility of losing the second connecting members 232, such that even if the protective cover 230 is detached and mounted multiple times, the protective cover 230 can also provide a relatively good protective effect for the switch assembly 220.

The protective cover 230 of the switch assembly 220 is arranged on the first wall 210 through two different connection modes. In the case where the switch assembly 220 does not need to be operated, the second connecting members 232 may maintain the fixed connection between the protective cover 230 and the first wall 210, such that the first wall 210 can maintain a good waterproof and dustproof effect, thereby lowering the possibility that impurities in the external environment enter the control box 200 to cause failure of the control box 200. In the case where the switch assembly 220 needs to be operated or maintained, the first connecting member 231 may enable the protective cover 230 to rotate relative to the first wall 210 without the need to completely detach the protective cover 230, such that the possibility of losing the protective cover 230 is reduced and the protection for the switch assembly 220 is facilitated, thus lowering the possibility of failure of the control box 200.

According to some embodiments of the present application, optionally, the protective cover 230 includes a first groove 233 opening toward the first wall 210, and the first groove 233 is configured to accommodate at least a part of the switch assembly 220; and/or, the first wall 210 is provided with a second groove 211 opening toward the protective cover 230, and the second groove 211 is configured to accommodate at least a part of the switch assembly 220.

FIG. 5 illustrates one side of the protective cover 230 facing the first wall 210. As shown in FIG. 5, a first groove 233 may be formed on the surface of the protective cover 230 facing the first wall 210. The opening of the first groove 233 faces the first wall 210. The first groove 233 has a certain accommodating space that can be configured to accommodate at least a part of the switch assembly 220. Optionally, the second groove 211 may be formed in the first wall 210 of the control box 200, the opening of the second groove 211 faces the protective cover 230, or it may also be considered that the opening of the second groove 211 faces the outside of the control box 200. The second groove 211 also has a certain accommodating space that can be configured to accommodate at least a part of the switch assembly 220.

In one possible control box 200, only the protective cover 230 is provided with the first groove 233. The first wall 210 may not be provided with the groove; the switch assembly 220 is arranged on the surface of the first wall 210 facing the outside of the control box 200, the switch assembly 220 protrudes from the first wall 210, and thus the first groove 233 may accommodate the part of the switch assembly 220 protruding from the first wall 210.

In another possible control box 200, only the first wall 210 is provided with the second groove 211, and the switch assembly 220 is arranged on the bottom wall of the second groove 211 and protrudes toward the outside of the control box 200 along the thickness direction of the first wall 210. In this case, the second groove 211 may accommodate the entirety of the switch assembly 220, and the protective cover 230 may not be provided with the groove.

In another possible control box 200, the protective cover 230 is provided with the first groove 233 and the first wall 210 is provided with the second groove 211. The first groove 233 and the second groove 211 together form a space for accommodating the switch assembly 220. Thus, the first groove 233 may accommodate one part of the switch assembly 220, and the second groove 211 may accommodate another part of the switch assembly 220.

By arranging the first groove 233 and/or the second groove 211 to accommodate the switch assembly 220, the clearance for the switch assembly 220 can be achieved, the possibility of interference between different structures is reduced, and the normal work of the control box 200 is facilitated, thus lowering the possibility of failure of the control box 200.

According to some embodiments of the present application, optionally, the first groove 233 is arranged opposite to the second groove 211.

In a control box 200 where the protective cover 230 is provided with the first groove 233 and the first wall 210 is provided with the second groove 211, the arrangement of the first groove 233 opposite to the second groove 211 may refer to that the opening of the first groove 233 substantially coincides with the opening of the second groove 211, and thus, the first groove 233 and the second groove 211, when combined, may be capable of forming a relatively large accommodating space to accommodate the switch assembly 220. In this case, the first groove 233 and the second groove 211 can accommodate the switch assembly 220 without having a relatively large depth. In one aspect, lowering the depth of the first groove 233 is conducive to lowering the dimension of the protective cover 230 protruding from the first wall 210, thus reducing the space of the energy storage device 100 additionally occupied, and improving the energy density of the energy storage device 100. In another aspect, lowering the depth of the second groove 211 is conducive for the first wall 210 to maintain relatively high strength at the second groove 211.

The arrangement of the first groove 233 opposite to the second groove 211 can reduce unnecessary space waste and facilitate the reasonable layout of the components on the control box 200, thus facilitating the fabrication of the control box 200 with a suitable dimension.

According to some embodiments of the present application, optionally, the first connecting member 231 is arranged on one side of the protective cover 230 facing the gravity direction G. The first groove 233 protrudes from the protective cover 230 along the first direction T, and the dimension of the first groove 233 protruding from the first wall 210 is greater than or equal to the dimension of the first connecting member 231 protruding from the first wall 210, where the first direction T is the thickness direction of the first wall 210.

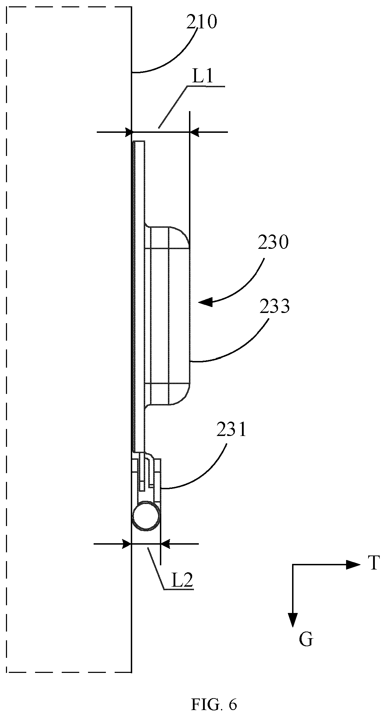

In some embodiments, the first connecting member 231 may be arranged on the edge of one side of the protective cover 230 facing the gravity direction G. Taking FIG. 6 as an example, FIG. 6 is a schematic diagram shown from one side of the control box 200, and the first connecting member 231 may be arranged on the bottom side of the protective cover 230 along the gravity direction G. In some embodiments, the control box 200 is placed in the energy storage device 100, and the first connecting member 231 may be located under the protective cover 230.

The first groove 233 is a groove opening toward the first wall 210 on the protective cover 230, and thus the first groove 233 protrudes from the protective cover 230 in a direction facing away from the first wall 210, and specifically, from the part of the protective cover 230 other than the first groove 233. The dimension L1 of the first groove 233 protruding from the first wall 210 refers to the farthest distance, in the thickness direction of the first wall 210, between the surface of the first groove 233 facing away from the first wall 210 and the first wall 210. The dimension L2 of the first connecting member 231 protruding from the first wall 210 refers to the farthest distance, in the thickness direction of the first wall 210, between the surface of the first connecting member 231 facing away from the first wall 210 and the first wall 210.

The dimension L1 of the first groove 233 protruding from the first wall 210 is greater than or equal to the dimension L2 of the first connecting member 231 protruding from the first wall 210, and thus the projection of the first groove 233 may cover the projection of the first connecting member 231 in the gravity direction G.

The part of the first groove 233 protruding from the first wall 210 can shield the first connecting member 231 in the gravity direction G, such that the first connecting member 231 is not easily affected by water accumulation or water seepage above the control box 200, thus lowering the possibility of damage caused by corrosion of the first connecting member 231 and facilitating the extension of the service life of the first connecting member 231.

According to some embodiments of the present application, optionally, the control box 200 further includes: a shielding structure 240, wherein the shielding structure 240 is arranged on one side of the first connecting member 231 along a direction opposite to the gravity direction G, and a projection of the shielding structure 240 in the gravity direction G covers the projection of the first connecting member 231 in the gravity direction G.

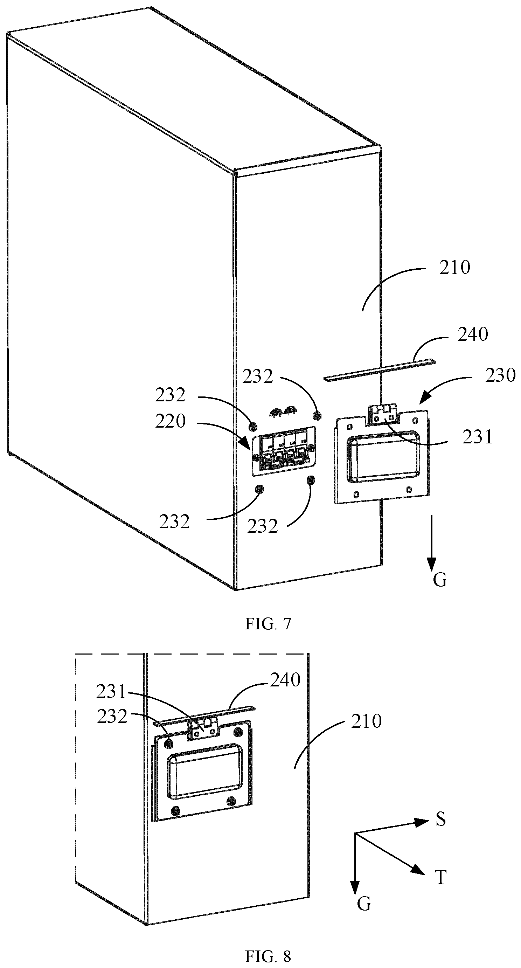

FIG. 7 illustrates a schematic diagram of an exploded structure of a control box 200 provided with a shielding structure 240, and FIG. 8 illustrates a schematic partial structural diagram of a control box 200 where the protective cover 230 is in a closed state.

The shielding structure 240 refers to a structure that protects the first connecting member 231. In some embodiments, the shielding structure 240 may at least shield the first connecting member 231 from dust or water that may fall in the gravity direction G, so as to lower the possibility that the service life of the first connecting member 231 is shortened due to the influence of the external environment.

The shielding structure 240 may have a variety of different shapes or structures. These shapes or structures need to meet the requirements that the projections thereof in the gravity direction G cover the projection of the first connecting member 231 in the gravity direction G. For example, the shielding structure 240 may be a thin plate. The thin plate may have an approximately rectangular parallelepiped shape and is capable of shielding the first connecting member 231 in the gravity direction G. That is, the shielding structure 240 can at least reduce the probability of impurities in the external environment vertically falling onto the first connecting member 231 in the gravity direction G.

The shielding structure 240 can reduce the accumulation of dust or water in the external environment on the first connecting member 231 for the first connection, and then lower the possibility of damage caused by corrosion of the first connecting member 231, and facilitate the extension of the service life of the first connecting member 231, thus lowering the possibility of failure of the control box 200.

According to some embodiments of the present application, optionally, the surface of the shielding structure 240 facing the direction opposite to the gravity direction G is the first surface 241, and the first surface 241 is inclined, in a second direction, from the central area to both ends along the gravity direction G, where the second direction is perpendicular to the thickness direction of the first wall 210 and the gravity direction G.

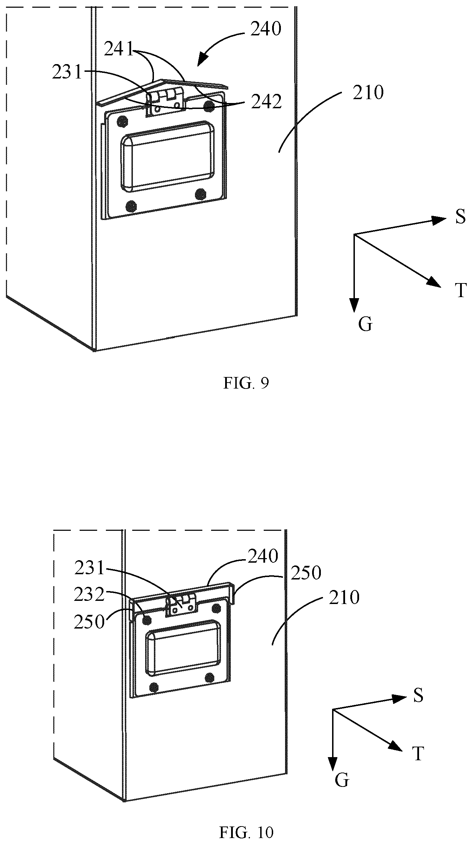

As shown in FIG. 9, in the case where the control box 200 is placed in the energy storage device 100, the first surface 241 may be an upper surface of the shielding structure 240. The central area of the first surface 241 may be slightly higher than the areas of both ends of the first surface 241 in the gravity direction G, so as to form a structure inclined from the central area to both ends.

Under the action of gravity, this type of structure is conducive to guiding dust or water to slide off along the inclined first surface 241 on the shielding structure 240, such that the dust or water does not accumulate on the shielding structure 240, thus reducing the load bearing of the shielding structure 240, and facilitating the extension of the service life of the shielding structure 240, thereby lowering the possibility of dust or water falling on the first connecting member 231 and lowering the possibility of failure of the control box 200.

In some embodiments, the first surface 241 may be inclined from one end in the second direction to the other end in the second direction.

In some embodiments, the surface of the shielding structure 240 facing the gravity direction G is the second surface 242, and the second surface 242 may be arranged substantially parallel to the first surface 241. Specifically, the second surface 242 may also be inclined, in the second direction, from the central area to both ends along the gravity direction G, and the area on the second surface 242 corresponding to the inclined part of the first surface 241 may be inclined at the same angle. Optionally, the second surface 242 may be inclined at a different angle.

In some embodiments, the second surface 242 may be arranged generally horizontally without being inclined.

According to some embodiments of the present application, optionally, the guiding part 250, the guiding part 250 is connected to the shielding structure 240 and arranged on both ends of the shielding structure 240 along the second direction, where the second direction is perpendicular to the thickness direction of the first wall 210 and the gravity direction G.

The guiding part 250 refers to a structure that is connected to the shielding structure 240 and may be configured to guide dust and water to slide off, as shown in FIG. 10. Both ends of the shielding structure 240 in the second direction may refer to the areas of both ends of the shielding structure 240 in the second direction, for example, the areas of the end parts of the shielding structure 240 in the upper, lower, left, and right positions. FIG. 10 illustrates the arrangement of the guiding part 250 along the gravity direction G. In some embodiments, the guiding part 250 may also be arranged inclined at a certain angle. For example, the guiding part 250 may be inclined from one end of the guiding part 250 connected to the shielding structure 240 to another end facing away from the protective cover 230 in the second direction.

In some embodiments, the guiding part 250 may also be arranged near the shielding structure 240 of a different shape or structure. For example, in the control box 200 shown in FIG. 9, the guiding part 250 may also be arranged at both ends of the shielding structure 240 along the second direction.

The guiding part 250 may further guide dust and water to slide off along a certain path, which is conducive to providing a better protective effect on the first connecting member 231. Meanwhile, the guiding part 250 may further reduce the accumulation of dust or water on the shielding structure 240 and lower the possibility that dust or water falls on the first connecting member 231, thus facilitating the extension of the service life of the first connecting member 231.

According to some embodiments of the present application, optionally, the control box 200 further includes a sealing member 260. The sealing member 260 is arranged between the protective cover 230 and the first wall 210 for sealing a surrounding area of the switch assembly 220.

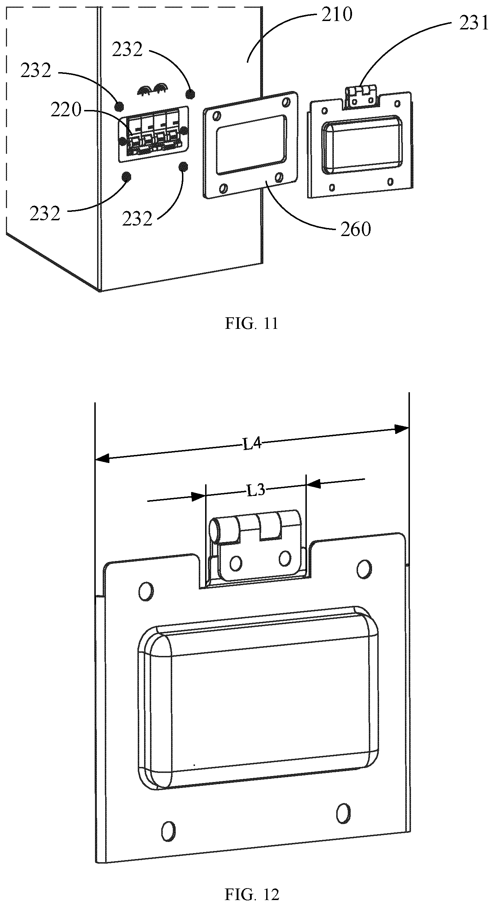

FIG. 11 illustrates an exploded structure of a control box 200 provided with a sealing member 260. The arrangement of the sealing member 260 between the protective cover 230 and the first wall 210 can fill the gap that possibly exists between the protective cover 230 and the first wall 210, thus reducing dust and water in the external environment entering the control box 200 through the gap between the protective cover 230 and the first wall 210. In some embodiments, the sealing member 260 may be arranged around the switch assembly 220 to fill the space around the switch assembly 220, so as to facilitate the sealing of the switch assembly 220 to be achieved in different directions.

In some embodiments, the sealing member 260 may have a certain elasticity and may be, for example, made of a rubber material. During the mounting process of the sealing member 260, the sealing member 260 may be compressed to achieve a better sealing effect.

In some embodiments, on the basis of the structure shown in FIG. 11, the shielding structure 240 and/or the guiding part 250 may be arranged on the control box 200, so as to further protect the first connecting member 231.

The sealing member 260 is conducive to sealing the periphery of the switch assembly 220, such that the control box 200 is not easily affected by dust and water in the external environment, thus lowering the possibility that impurities in the external environment enter the control box 200 to cause failure of the control box 200 and enabling the waterproof and dustproof effect of the control box 200 to be further improved, thereby lowering the possibility of failure of the control box 200.

According to some embodiments of the present application, optionally, the second connecting members 232 are configured to connect the first wall 210, the sealing member 260, and the protective cover 230.

In the case where the control box 200 is provided with the sealing member 260, the second connecting members 232 may further fixedly connect the first wall 210, the sealing member 260, and the protective cover 230. The second connecting members 232 are detachable fixed connecting structures. In the case where the sealing member 260 needs to be replaced or inspected, the second connecting members 232 may be detached and then the sealing member 260 is subjected to the operation.

In the case where the protective cover 230 maintains fixed connection to the first wall 210, by connecting the first wall 210, the sealing member 260, and the protective cover 230 through the second connecting members 232, the three components may be more tightly disposed together, which is conducive to improving the sealing performance of the sealing member 260.

According to some embodiments of the present application, optionally, in the length direction of an edge area, a value range of the ratio of a length L3 of the first connecting member 231 to a length L4 of the edge area is [1/4, 1/2].

In some embodiments, the protective cover 230 may be of a polygonal structure, and the first connecting member 231 may occupy a part of the edge area of the protective cover 230. As shown in FIG. 12, the length L4 of the edge area of the protective cover 230 refers to the maximum length of the edge of the protective cover 230, on which the first connecting member 231 is arranged, in a direction where the edge extends, and the length L3 of the first connecting member 231 refers to the maximum length of the first connecting member 231 in the same direction. In some embodiments, the value range of the ratio of the length L3 of the first connecting member 231 to the length L4 of the edge area is [1/4, 1/2].

If the ratio of the length L3 of the first connecting member 231 to the length L4 of the edge area is too small, it may be difficult to maintain the connection between the protective cover 230 and the first wall 210, which may easily lead to damage to the first connecting member 231 during use. If the ratio of the length L3 of the first connecting member 231 to the length L4 of the edge area is too large, the possibility that dust and water in the external environment enter the switch assembly 220 through the gap between the first connecting member 231 and the first wall 210 is likely to be increased, thus leading to the increase in the probability of failure of the control box 200.

According to some embodiments of the present application, optionally, the first connecting member 231 includes a hinge, and/or the second connecting members 232 include bolts.

By rotatably connecting the protective cover 230 to the first wall 210 through the hinge, the rotation of the protective cover 230 relative to the first wall 210 may be convenient to achieve. In some embodiments, by connecting the protective cover 230 and the first wall 210 through the bolts, the detachment and mounting between the protective cover 230 and the first wall 210 can be achieved through a relatively mature process, thus lowering the manufacturing cost.

The present application further provides an energy storage device 100, which includes the control box 200 described in any one of the above embodiments.

The above descriptions are only embodiments of the present application, but the protection scope of the present application is not limited thereto. Any variations or substitutions that can be easily conceived by those skilled in the art within the technical scope disclosed in the present application shall be covered by the protection scope of the present application. Therefore, the protection scope of the present application shall be subjected to the protection scope of the claims described.

## Claims

1. A control box in an energy storage device, comprising:
a first wall;
a switch assembly, the switch assembly being arranged on the first wall; and
a protective cover, wherein the protective cover covers the switch assembly, an edge area of the protective cover is rotatably connected to the first wall through a first connecting member, and the protective cover is fixedly connected to the first wall through detachable second connecting members.

2. The control box according to claim 1, wherein the protective cover comprises a first groove opening toward the first wall, the first groove being configured to accommodate at least a part of the switch assembly; and/or
the first wall is provided with a second groove opening toward the protective cover, the second groove being configured to accommodate at least a part of the switch assembly.

3. The control box according to claim 2, wherein the first groove is arranged opposite to the second groove.

4. The control box according to claim 2 or 3, wherein the first connecting member is arranged on one side of the protective cover facing a gravity direction, the first groove protrudes from the protective cover along a first direction, and a dimension of the first groove protruding from the first wall is greater than or equal to a dimension of the first connecting member protruding from the first wall, wherein the first direction is a thickness direction of the first wall.

5. The control box according to any one of claims 1 to 4, wherein the control box further comprises:
a shielding structure, wherein the shielding structure is arranged on one side of the first connecting member along a direction opposite to the gravity direction, and a projection of the shielding structure in the gravity direction covers a projection of the first connecting member in the gravity direction.

6. The control box according to claim 5, wherein a surface of the shielding structure facing the direction opposite to the gravity direction is a first surface, and the first surface is inclined, in a second direction, from a central area to both ends along the gravity direction, wherein the second direction is perpendicular to the thickness direction of the first wall and the gravity direction.

7. The control box according to claim 5 or 6, wherein the control box further comprises:
a guiding part, the guiding part being connected to the shielding structure and arranged on both ends of the shielding structure along the second direction, the second direction being perpendicular to the thickness direction of the first wall and the gravity direction.

8. The control box according to any one of claims 1 to 7, wherein the control box further comprises:
a sealing member, the sealing member being arranged between the protective cover and the first wall for sealing a surrounding area of the switch assembly.

9. The control box according to claim 8, wherein the second connecting members are configured to connect the first wall, the sealing member, and the protective cover.

10. The control box according to any one of claims 1 to 9, wherein in a length direction of the edge area, a value range of a ratio of a length of the first connecting member to a length of the edge area is [1/4, 1/2].

11. The control box according to any one of claims 1 to 10, wherein the first connecting member comprises a hinge, and/or the second connecting members comprise bolts.

12. An energy storage device, comprising:
the control box according to any one of claims 1 to 11.
